# EUROPEAN PATENT SPECIFICATION

(11) **EP 0 334 381 B1**
(45) Date of publication and mention of the grant of the patent: **14.02.1996**
(21) Application number: 89105301.9
(22) Date of filing: 23.03.1989
(51) Int. Cl.: G03F 7/008

(54) **Coating film comprising a negative-working photosensitive composition and pattern-formation method**
Beschichtungsfilm enthaltend eine negativ arbeitende lichtempfindliche Zusammensetzung und Bilderzeugungsverfahren
Film de revêtement contenant une composition photosensible négative et procédé pour obtenir des images

(30) Priority: 23.03.1988 JP 69082/88
(43) Date of publication of application: 27.09.1989
(73) Proprietor: HITACHI, LTD., Chiyoda-ku, Tokyo 100 (JP); Hitachi Chemical Co., Ltd., Shinjuku-ku, Tokyo 160 (JP)
(72) Inventor: Toriumi, Minoru, Hachioji-shi (JP); Hayashi, Nobuaki, Iruma-gun Saitama-ken (JP); Hashimoto, Michiaki, Sayama-shi (JP); Ueno, Takumi, Hachioji-shi (JP); Iwayanagi, Takao, Tokyo (JP)
(74) Representative: Strehl Schübel-Hopf Groening & Partner

(56) References cited:
- IEEE TRANSACTIONS ON ELECTRON DEVICES, vol. ED-28, no. 11, November 1981, NEW YORK, US; pages 1306-1310; TAKAO IWAYANAGI et al: "Azide-Phenolic Resin Photoresists for Deep UV Lithography"
- PATENT ABSTRACTS OF JAPAN vol. 8, no. 55 (P-260)(1492) 13 March 1984 & JP-A-58 203438
- PATENT ABSTRACTS OF JAPAN vol. 8, no. 133 (P-281)(1570) 20 June 1984 & JP-A-59 36245
- PHOTOGRAPHIC SCIENCE AND ENGINEERING, vol. 17, no. 4, 1973, WASHINGTON, US; pages 390-393; TAKAHIRO TSUNODA et al: "Spectral sensitization of bisazide compounds"
- AUSTRALIAN JOURNAL OF CHEMISTRY, vol. 20, no. 7, 1967, EST MELBOURNE, AU; pages 1395-1402; DYALL L.K., KEMP J.E.: "The infrared spectra of aryl azides"

## Description

### BACKGROUND OF THE INVENTION

This invention relates to a photosensitive coating film made of negative working composition and a pattern-formation method with such a coating film, and more particularly to a coating film made of a photoresist (a photosensitive etching-resistant coating material) and a pattern-formation method which are suitable for microfabrication.

Photosensitive compositions are used for various purposes, for example, production of semiconductor devices. For improving the performance of semiconductor devices particularly for Large-scale integration, Very Large-scale integration, etc., it is necessary to improve the precision of fabrication of the semiconductor devices.

At present, reduction projection printers of g-line (436 nm) are widely used for exposure. For improving the precision of fabrication, efforts are made to increase the numerical aperture (NA) of a reduction projection printer or shorten the exposing wavelength from g-line to i-line (365 nm). It is technically difficult to increase the NA without decreasing the exposure area. Even if an exposing apparatus having a high NA can be produced, its focus depth is small so that a process using a single layer of coating cannot be used, resulting in practical problems. The shortening of the exposing wavelength is fairly hopeful in practice. Needless to say, even if the exposing wavelength is shortened, a resist is still required to have a high resolution and the like.

Recently, there is noted an exposure process using Krypton Fluoride (KrF) excimer laser among light sources of short wavelength. This is because the exposing wavelength of KrF excimer laser is as fairly short as 248 nm and its output is large and stable. For example, the result of KrF excimer laser exposure by use of MP2400 (mfd. by Shipley Japan) as positive type photoresist has been reported in "Collection of preliminary manuscripts for lectures to the scientific lecture meeting of the 47th Japan Applied Physics Society" p. 323, 29a-ZF-2 (1986). In addition, the result of KrF excimer laser exposure by use of PMMA as positive type photoresist has been reported in "Collection of preliminary manuscripts for lectures to the 34th Japan Applied Physics Association", the 2nd fascicle, p. 432, 30a-N-8 (1987).

In the above prior arts, neither sensitivity nor resolution is taken into consideration, and it is difficult to attain high sensitivity and high resolution at the same time in the prior arts. In detail, at film thickness of 1 µm, MP2400 has an absorbance at 248 nm of 0.46, which is rather large for a positive type photoresist. Therefore, incident light does not reach the lower part of photoresist sufficiently, so that the cross section of a pattern of MP2400 has a considerably undesirable shape, i.e., an undercut shape. On the other hand, PMMA absorbs light too weakly, hence it has a sensitivity of as low as 32 J/cm which is disadvantageous for practical use. Furthermore, PMMA has a defect in that when it is used on a silicon wafer, 80% or more of incident light reaches the silicon wafer substrate and therefore a large standing wave is raised, so that a fine pattern cannot be resolved.

Coating films having a negative working photosensitive composition as disclosed in the precharacterising part of claim 1 are known from T. Iwayanagi et al., "Azide-Phenolic Resin Photoresists for Deep UV Lithography", IEEE Transactions on Electron Devices, Vol. ED-28, No. 11 (1981), pp. 1306 - 1310. Further photosensitive compositions and methods for pattern formation with such photosensitive compositions are described in JP-A-58 203438, JP-A-59 36245 and T. Tsunoda et al., "Spectral sensitization of bisazide compounds", Vol. 17, No. 4,(1973), pp. 390 - 393.

### SUMMARY OF THE INVENTION

It is the object of this invention to provide a photosensitive material having high sensitivity and resolution for light having a short wavelength, for example, 248 nm which is an exposing wavelength of KrF excimer laser, and a pattern-formation method using said photosensitive material.

This object is met by a coating film according to claim 1 and a method of a pattern formation with a coating film according to claim 4. Preferred embodiments are described in the subclaims.

The negative-working photosensitive composition contains at least one aromatic azide compound and a polymer compound. The numerical value of product of the film thickness expressed in micron of a coating film of said photosensitive composition and its absorbance at 248 nm ranging from 0.5 to 1.5. The pattern-formation method comprises a step of spin-coating the photosensitive composition comprising at least one aromatic azide compound and a polymer compound on a substrate to form a coating film, a step of exposing the coating film to light to print a predetermined pattern, and a step of forming the predetermined negative pattern by development.

When the transmittance of a negative type photoresist is too low, the light absorption on the surface of coating film is so strong that a pattern formed by development has an undercut shape, and hence formation of a pattern having edges perpendicular to a substrate and control of the linewidth is difficult. On the other hand, when the transmittance is too high, the pattern is liable to be affected by the reflection of light from a substrate and the geography of the substrate.

In the present invention, the absorbance of the coating film can be adjusted to a predetermined value by properly determining the proportion of the aromatic azide compound as photosensitive constituent to the polymer compound.

As light having a short wavelength, there can be used light of KrF excimer laser having an oscillation wavelength range of 247 to 249 nm. In addition to this light, there can be used lights of Argon Fluoride (ArF) excimer laser (oscillation wavelength 193 nm), Krypton chloride (KrCl) excimer laser (oscillation wavelength 222 nm), Xenon chloride (XeCl) excimer laser (oscillation wavelength 308 nm), etc. Employment of a laser, in particular, an excimer laser, is advantageous in that since it has a short wavelength in a very small wavelength region so that the light absorption in other wavelength regions by a sensitizer need not be taken into consideration, usable sensitizers are increased.

The azide compound used in this invention is one which has an absorption band at a short exposing wavelength. Since employment of an excimer laser as light source results in a small exposing wavelength region, compounds having an absorption band at wavelengths longer than the exposing wavelength can also be used.

Such azide compounds include, for example, the following aromatic azide compounds:
4,4'-diazido-3,3'-dimethoxybiphenyl 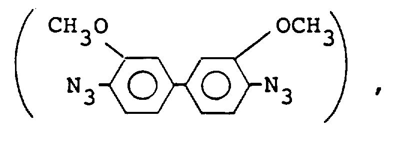
3,3'-diazidodiphenylsulfone 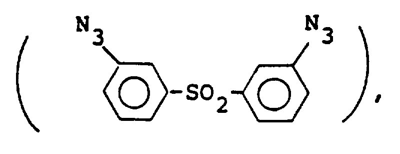
4-nitro-2-methylphenylazide 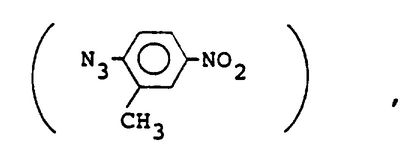
3,4'-diazidodiphenylsulfone 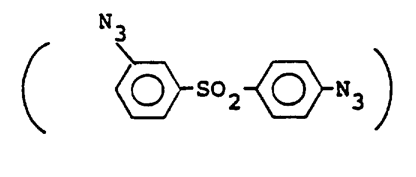
Two or more of such compounds can be simultaneously used.

Although the amount of the azide compound, if considered precisely, is somewhat varied depending on, for example, the sensitivity characteristics and optical characteristics of each azide compound used, it is usually preferably in the range of about 5 - 30 weight%, more preferably about 5 - 25 weight%, based on the total weight (the sum of the weight of the azide compound and the polymer compound).

As the polymer compound used in the present invention, there can be used polymer compounds which are used in conventional negative type photoresists. In particular, alkali-soluble polymer compounds are preferable and among them, dry etching resistant ones are more preferable. Many of such polymer compounds have aromatic ring/s. They include, for example, condensation products between phenols and formaldehyde, such as cresol novolak resins 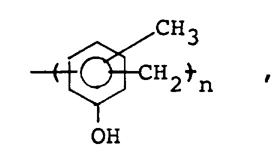 copolymers containing phenols, hydroxystyrene polymers 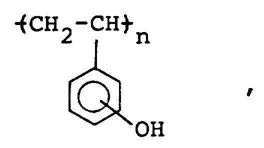 and copolymers containing hydroxystyrene.

In the present invention, the wavelength of light for exposure is shorter than 436 nm which is a conventional exposing wavelength, and hence the resolution is improved. For example, when said wavelength is 248 nm, the minimum resolvable line width is smaller than that attained at the conventional exposing wavelength of 436 nm by as much as 57%.

In the present invention, when the numerical value of product of the thickness expressed in micron of the coating film and its absorbance at a predetermined exposing wavelength is 0.5 to 1.5, for example, when said absorbance is 0.5 to 1.5 in the case where the coating film has a thickness of 1 µm, the cross section of the coating film after exposure and development is such that its edge is substantially perpendicular to the surface of the substrate. When said numerical value of product is adjusted to less than 0.5, for example, 0.4, the cross section of the coating film after exposure and development has a gently overcut shape. On the other hand, when said product is adjusted to more than 1.5, for example, 1.6, the cross section of the coating film has an undercut shape. Therefore, both of such values of said product are not desirable.

When the coating film of the photosensitive composition of the present invention is exposed to light, the amount of light which reaches the substrate is, for example, about 10%. Therefore, the effect of standing wave is small, the cross section of the coating film mentioned above does not have a gently overcut shape. On the other hand, when the absorption of light by the coating film is excessive, said cross section has an undercut shape, but such a phenomenon is not observed in the above range of numerical value of said product.

### BRIEF DESCRIPTION OF THE DRAWINGS

Fig. 1 is a curve showing the sensitivity characteristics of the photosensitive composition of the present invention.

Fig. 2 is a curve showing the relationship between the angle of pattern and the numerical value of product of film thickness and absorbance, for the photosensitive composition of the present invention.

Fig. 3 illustrates the definition of the angle of the resist pattern of the present invention.

### DETAILED DESCRIPTION OF PREFERRED EMBODIMENT

### EXAMPLES

The present invention is illustrated with the following examples. The aromatic azide compound used in this invention includes also novel compounds. Therefore first, synthesis example of one of the novel azide compounds is described.

### Synthetic method of 3,4'-diazidodiphenylsulfone

In 20 ml of a solution of concentrated hydrochloric acid and water in the ratio of 1 : 1 is dissolved 3.4 g of 3,4'-diaminodiphenylsulfone. A solution of 2.1 g of sodium nitrite in 5 ml of water is added to the resulting solution with ice-cooling (3° to 5°C). After stirring with ice-cooling for 2 hours, 3.5 g of sodium azide is added to the resulting solution of tetrazonium salt, upon which foaming occurs and white precipitate is formed. The filtrate is filtered, rinsed with water, and then recrystallized from benzene to obtain 3,4'-diazidodiphenylsulfone as white kneedle-like crystals having a melting point of 117.5° - 118.2°C. This compound has a wavelength of maximum photo-absorption at 267 nm in ethanol.

### Example 1

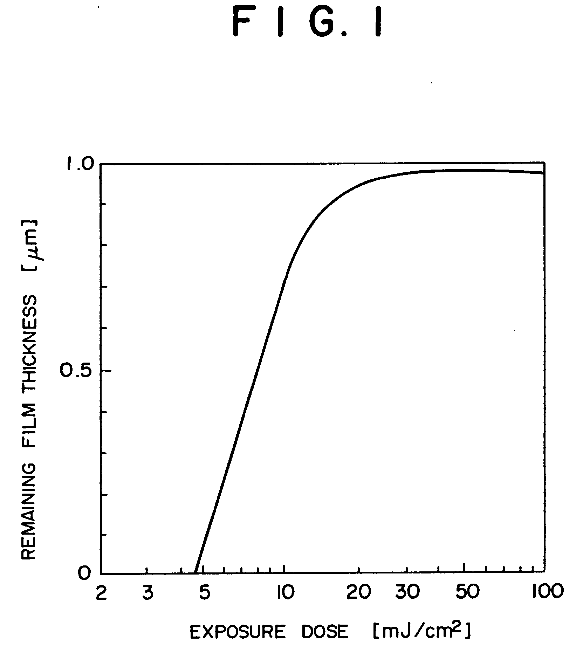

A photoresist solution having a composition described below was prepared. Poly(p-hydroxystyrene) having a transmittance at 248 nm of 50% at film thickness of 1 µm and 4,4'-diazido-3,3'-dimethoxybiphenyl were dissolved in the ratio of 10 : 1 by weight in cyclohexanone to obtain a photoresist solution. The photoresist solution was spin-coated on a silicon wafer and baked at 80°C for 10 minutes to form a coating film of 1 µm in thickness. The numerical value of product of the absorbance and the thickness of the film was 0.5. The film was exposed to light by means of a KrF excimer laser (mfd. by Lambda Physik) at various irradiation doses and at various irradiation positions. After the exposure, the coating film was developed with a 1.19% aqueous tetramethylammonium hydroxide solution for 130 seconds. By this procedure, the coating film in the unexposed area was removed, and only a portion of the coating film insolubilized by the exposure remained on the wafer. The film thickness after the development was measured by means of a stylus thickness monitor (Alpha-Step 200, mfd. by Tencor Instruments) and plotted against the exposure dose to obtain a sensitivity curve of the photoresist. The sensitivity curve thus obtained is shown in Fig. 1.

From Fig. 1, it can be seen that the photosensitive composition of the present invention has a sensitivity (8 mJ/cm) and contrast characteristics (2.3) which are sufficiently high for practical use.

Said photosensitive composition had such high sensitivity and such high contrast because the sensitizer used in the present resist was the most suitable and the numerical value of product of the absorbance and the film thickness was adjusted to the optimum value.

A coating film formed in the same manner as described above was exposed to light from the KrF excimer laser at a dose of 30 mJ/cm through a hard mask having a pattern width of 0.5 µm. After the exposure, the coating film was developed with a 1.19% aqueous tetramethylammonium hydroxide solution for 130 seconds to obtain a satisfactory pattern having a width of 0.5 µm.

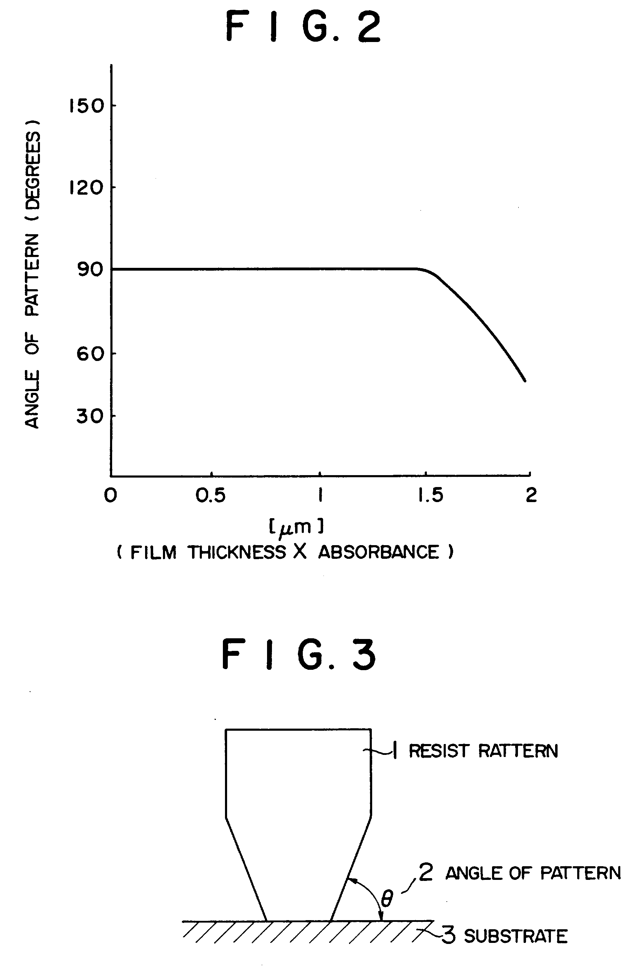

In Fig. 2 is shown, for the present resist, the dependence of the angle of pattern after exposure and development on the product of the absorbance and the film thickness. Here, the term "angle of pattern" means the angle θ at the bottom of resist pattern shown in Fig. 3. As is clear from Fig. 2, when the numerical value of product of the absorbance and the film thickness is more than 1.5, an undercut pattern shape is obtained and hence the resist is not suitable for microfabrication. On the other hand, when said numerical value of product is less than 0.5, the reflection of light from the substrate is much and hence the resist is not suitable for microfabrication.

Thus, the control of the product of the absorbance and the film thickness is very important for practical purposes. In the case of the resist of the present example in which the numerical value of said product was made most suitable, a satisfactory pattern shape having a width of 0.5 µm was obtained.

### Example 2

The process of Example 1 was repeated except that in place of 4,4'-diazido-3,3'-dimethoxybiphenyl, 3,3'-diazidodiphenylsulfone and 4,4'-diazido-3,3'-dimethoxybiphenyl were blended with the base resin so as to adjust the ratio among the three to 10 : 0.55 : 0.55 by weight. The numerical value of product of the absorbance and the film thickness of the film thus obtained was 1.0.

Thus, the sensitivity was 26 mJ/cm and the contrast 1.5, and a satisfactory pattern having a width of 0.45 µm was obtained.

### Example 3

The process of Example 1 was repeated except that poly(ρ-hydroxystyrene) having a transmittance at 248 nm of 30% at film thickness of 1 µm (mfd. by Maruzen Oil Co., Ltd.) was used in place of the poly(ρ-hydroxystyrene) having a high transmittance described in Example 1. The numerical value of product of the absorbance and the film thickness of the film thus obtained was 0.7.

Thus, the sensitivity was 10 mJ/cm and the contrast 1.1, and a satisfactory pattern having a width of 0.5 µm was obtained.

### Example 4

The process of Example 1 was repeated except that poly(ρ-hydroxystyrene) having a transmittance at 248 nm of 30% at film thickness of 1 µm (mfd. by Maruzen Oil Co., Ltd.) was used in place of the poly(ρ-hydroxystyrene) having a high transmittance described in Example 1, and that in place of 4,4'-diazido-3,3'-dimethoxybiphenyl, 4-nitro-2-methylphenylazide was blended with the base resin in the ratio of 10 : 4.3 by weight. The numerical value of product of the absorbance and the film thickness of the film thus obtained was 0.7. Thus, the sensitivity was 18 mJ/cm and the contrast 1.5, and a satisfactory pattern having a width of 0.5 µm was obtained.

### Example 5

The process of Example 1 was repeated except that poly(ρ-hydroxystyrene) having a transmittance at 248 nm of 30% at film thickness of 1 µm (mfd. by Maruzen Oil Co., Ltd.) was used in place of the poly(ρ-hydroxystyrene) having a high transmittance described in Example 1 and that in place of 4,4'-diazido-3,3'-dimethoxybiphenyl, 3,4'-diazidodiphenylsulfone was blended with the base resin in the ratio of 10 : 0.84 by weight. The numerical value of product of the absorbance and the film thickness of the film thus obtained was 1.4. Thus, the sensitivity was 23 mJ/cm³ and the contrast 1.4, and a satisfactory pattern having a width of 0.6 µm was obtained.

### Example 6

The process of Example 1 was repeated except that cresol novolak resin having a transmittance at 248 nm of 50% at film thickness of 1 µm (mfd. by Hitachi Chemical Company, Ltd.) was used in place of the poly(ρ-hydroxystyrene) having a high transmittance described in Example 1. The numerical value of product of the absorbance and the film thickness of the film thus obtained was 0.5.

Thus, the sensitivity was 30 mJ/cm and the contrast 1.5, and a satisfactory pattern having a width of 0.5 µm was obtained.

### Comparative Example 1

The process of Example 1 was repeated except that the weight ratio described in Example 1 was changed to 10 : 5.

The absorbance of the thus obtained coating film of 1 µm in thickness was 4.5, and no satisfactory pattern was obtained because of too strong light absorption by the film.

### Comparative Example 2

The process of Example 1 was repeated except that the weight ratio described in Example 1 was changed to 10 : 0.3.

The absorbance of the thus obtained coating film was 0.3, and owing to insufficient crosslinking, the film thickness was greatly decreased, so that satisfactory pattern could not be obtained.

According to the present invention, a pattern can be obtained at high resolution by exposure and development by adjusting the numerical value of product of the film thickness expressed in micron and the absorbance at a predetermined wavelength (e.g. 248 nm) of the coating film to the range from 0.5 to 1.5 and exposing the coating film to light having the above predetermined wavelength. The edge of cross section of the pattern thus formed is substantially perpendicular to the surface of substrate. Moreover, the photosensitive composition of the present invention is a negative type photoresist hence it is advantageous in that during exposure, the amount of light which reaches the substrate is small, so that the reflection of light from the substrate causes only small influence.

When a polymer compound having benzene ring/s is used as the polymer compound in the composition of the present invention, said composition has a sufficient dry etching resistance hence it is very useful for practical purposes.

## Claims

1. A coating film made of a negative working photosensitive composition consisting essentially of at least one aromatic azide compound selected from the group consisting of 4,4'-diazido-3,3'-dimethoxybiphenyl, 3,3'-diazidodiphenylsulfone, 4-nitro-2-methylphenyl-azide and 3,4'-diazido-diphenylsulfone, and an alkali-soluble polymer compound characterized in that the absorbance to the radiation of 248 nm wavelength of the coating film having a thickness of 1 µm ranges from 0.5 to 1.5.

2. The coating film according to claim 1, wherein said alkali-soluble polymer compound is a member selected from the group consisting of cresol novolak resins, phenol copolymers, hydroxystyrene and hydroxystyrene copolymers.

3. The coating film according to claim 1 or 2, wherein the aromatic azide compound amounts to 5 to 30 weight percents of the total weight of the aromatic azide compound and the alkali-soluble polymer compound.

4. A method for a pattern formation with the coating film made of a negative working photosensitive composition according to claims 1 to 3, characterised by the steps of:
coating said composition on the substrate to form the coating film,
exposing the coating film to a light by a KrF excimer laser source to print a predetermined negative pattern, and
forming the predetermined negative pattern by development.

## Patentansprüche

1. Überzugschicht, hergestellt aus einer negativ kopierenden, photosensitiven Zusammensetzung, die im wesentlichen aus mindestens einer aromatischen Azidverbindung, die ausgewählt ist aus der Gruppe 4,4'-Diazido-3,3'-dimethoxybiphenyl, 3,3'-Diazidodiphenylsulfon, 4-Nitro-2-methylphenyl-azid und 3,4'-Diazidodiphenylsulfon, und einer in Alkali löslichen Polymerverbindung besteht, dadurch **gekennzeichnet**, daß die Extinktion bei einer Bestrahlung der Überzugschicht mit einer Dicke von 1 µm bei einer Wellenlänge von 248 nm 0,5 bis 1,5 beträgt.

2. Überzugschicht gemäß Anspruch 1, wobei die in Alkali lösliche Polymerverbindung eines von den Cresol-Novolak-harzen, Phenol-Copolymeren, Hydroxystyrol oder HydroxystyrolCopolymeren ist.

3. Überzugschicht gemäß Anspruch 1 oder 2, wobei die aromatische Azidverbindung 5 bis 30 Gew.-% des Gesamtgewichts der aromatischen Azidverbindung und der in Alkali löslichen Polymerverbindung ausmacht.

4. Verfahren zur Herstellung einer Musterstruktur mit der Überzugschicht, die aus einer negativ kopierenden, photosensitiven Zusammensetzung gemäß einem der Ansprüche 1 bis 3 besteht, **gekennzeichnet** durch die Schritte
Aufbringen der Zusammensetzung auf dem Substrat, um eine Überzugschicht zu bilden,
Bestrahlen der Überzugschicht mit einem Strahl aus einer KrF-Excimerlaserquelle, um ein vorbestimmtes negatives Muster aufzudrucken, und
Ausbilden des vorbestimmten negativen Musters durch Entwickeln.

## Revendications

1. Film de revêtement fait d'une composition photosensible négative constituée essentiellement d'au moins un composé de type azoture aromatique choisi dans le groupe constitué par le 4,4'-diazido-3,3'-diméthoxybiphényle, la 3,3'-diazidodiphénylsulfone, l'azoture de 4-nitro-2-méthylphényle et la 3,4'-diazidodiphénylsulfone et d'un composé polymère soluble dans les bases, caractérisé en ce que, pour le rayon présentant une longueur d'onde de 248 nm, l'absorbance du film de revêtement ayant une épaisseur de 1 µm varie dans l'intervalle de 0,5 à 1,5.

2. Film de revêtement selon la revendication 1, dans lequel ledit composé polymère soluble dans les bases est un membre choisi dans le groupe constitué par des résines crésol-novolaques, des copolymères de phénol, des polymères d'hydroxystyrène et des copolymères d'hydroxystyrène.

3. Film de revêtement selon la revendication 1 ou 2, dans lequel ledit composé de type azoture aromatique représente de 5 à 30% du poids total du composé de type azoture aromatique et du composé polymère soluble dans les bases.

4. Procédé pour former un motif avec le film de revêtement fait d'une composition photosensible négative selon les revendications 1 à 3, caractérisé en ce qu'il comprend les étapes consistant à:
revêtir le substrat avec ladite composition pour former le film de revêtement,
exposer le film de revêtement à une lumière émise par une source de rayon laser à excimères KrF pour imprimer un motif négatif prédéterminé, et
former le motif négatif prédéterminé par développement.
